# EUROPÄISCHE PATENTSCHRIFT

(11) **EP 0 324 523 B1**
(45) Veröffentlichungstag und Bekanntmachung des Hinweises auf die Patenterteilung: **02.06.1993**
(21) Anmeldenummer: 89200038.1
(22) Anmeldetag: 09.01.1989
(51) Int. Cl.: C23C 16/50, C23C 16/52, C23C 16/30

(54) **Verfahren zur plasmaaktivierten reaktiven Abscheidung von elektrisch leitendem Mehrkomponentenmaterial aus einer Gasphase**
Process for the plasma-activated reactive deposition of a multi-component conductive material from a gas phase
Procédé de déposition réactive en phase gazeuse activée par plasma d'un matériau multicomposant électriquement conducteur

(30) Priorität: 13.01.1988 DE 3800712
(43) Veröffentlichungstag der Anmeldung: 19.07.1989
(73) Patentinhaber: Philips Patentverwaltung GmbH, 22335 Hamburg (DE); Philips Electronics N.V., 5621 BA Eindhoven (NL)
(72) Erfinder: Gärtner, Georg, Dr., D-5100 Aachen (DE); Janiel, Peter, D-5102 Würselen (DE); Lydtin, Hans, Dr., D-5190 Stolberg (DE)
(74) Vertreter: Koch, Ingo

(56) Entgegenhaltungen:
- EP-A- 0 027 625
- EP-A- 0 119 058
- EP-A- 0 204 356
- EP-A- 0 207 767

## Beschreibung

Die Erfindung betrifft ein PCVD-Verfahren, d.h. ein Verfahren zur plasmaaktivierten reaktiven Abscheidung von elektrisch leitendem Mehrkomponentenmaterial aus einer strömenden Gasphase auf einem rohrförmigen Substrat, wobei das Plasma zwischen einer Innenelektrode und einer Außenelektrode, von denen eine rohrförmig ausgebildet ist und als Substrat dient, erzeugt wird.

Ein Verfahren ähnlicher Art ist aus EP-A-O 204 356 bekannt. Bei dem darin beschriebenen Verfahren wird zwischen der Innenelektrode und der Außenelektrode eine lokal begrenzte Glimmentladungszone erzeugt, die während der Abscheidung beibehalten wird. Dabei erfolgt eine gesteuerte Hin- und Herbewegung der Innenelektrode relativ zur Außenelektrode und es werden Maßnahmen getroffen, um die Bildung von elektrisch leitenden Schichten auf elektrisch isolierenden Konstruktionsteilen im Reaktionsraum zu verhindern. Die Temperatur im Substratbereich wird auf einem niedrigen Wert konstant gehalten, bei dem die thermische Abscheiderate klein ist gegenüber der Abscheiderate mit Glimmentladung.

Mit dem bekannten Verfahren werden z.B. selbsttragende elektrisch leitende thorierte Wolframzylinder hergestellt. Die Konzentration von Thoriumoxid in Wolfram liegt dabei zwischen 0,5 und 10 Gew.%. Das Verfahren ist zur Dotierung von Wolfram oder anderen Refraktärmetallen sowohl mit Actiniden und deren Oxiden als auch mit Scandium, Yttrium und Seltenerdmetallen und deren Oxiden geeignet. Anstelle selbsttragender Zylinder können auch Überzüge auf vorhandenen Strukturen nach dem bekannten Verfahren hergestellt werden.

Bei Untersuchungen, die zur Erfindung geführt haben, hat sich herausgestellt, daß metallorganische Ausgangsverbindungen sich zwar bei Molverhältnissen von W:Th (oder einem anderen Element aus der IIIB-Gruppe des Periodensystems) im Bereich von etwa 20:1 gut verwenden lassen, ohne daß zu viel unerwünschter Kohlenstoff oder unerwünschtes Fluor abgeschieden werden, daß dies aber nicht mehr gilt, wenn man das Molverhältnis um eine Größenordnung ändert und statt einer Dotierung eine Mischung herstellen will, z.B. von W:Sc im Molverhältnis 2:1 oder 3:1.

Eine Anwendung in dieser Richtung ist das Überziehen von I-Kathoden, d.h. imprägnierten Ba, Sr-Nachlieferungsglühkathoden, mit einer W + 13 Gew.% Sc₂O₃-Schicht per PCVD, wodurch eine verbesserte Scandatkathode mit hoher Elektronenemission und Resistenz gegen Ionenbombardement (100%ige Erholung) erhalten werden soll. Analog zur Herstellung von Th/W-Kathoden per PCVD wurden nun per PCVD Sc/W-Materialien, auch verwendbar als scandierte W-Glühkathoden, hergestellt, und zwar unter Verwendung von Sc-β-diketonaten als Ausgangsverbindungen. Bei Erhöhung der Sc-Konzentration auf 10 Gew.% und mehr, was etwa einem Molverhältnis zwischen W und Sc von 2,5:1 entspricht, wurden nach der PCVD-Abscheidung statt W und Sc₂O₃ die Phasen W₂C bzw. W₂(C,O) und ScF₃ gefunden.

Der Erfindung liegt die Aufgabe zugrunde, Maßnahmen zu treffen, um die gewünschten Festkörperphasen, d.h. Mehrkomponentenmaterial gewünschter Zusammensetzung, per PCVD zu erhalten.

Diese Aufgabe wird erfindungsgemäß dadurch gelöst, daß die Zusammensetzung der Gasphase zeitlich und/oder räumlich verändert wird, indem zwischen reaktiven Abscheidungsphasen Plasma-Zwischenbehandlungen durchgeführt und/oder einzelne Komponenten der Gasphase über räumlich getrennte Gaseinlässe in getrennte Plasmabereiche eingebracht werden.

Als Ausgangsmaterial für das Mehrkomponentenmaterial werden der strömenden Gasphase vorzugsweise flüchtige Metallverbindungen, insbesondere Metallhalogenide und metallorganische Verbindungen, zugesetzt. Dabei werden fluorfreie metallorganische Verbindungen bevorzugt; dies wird weiter unten noch näher erläutert.

Beim erfindungsgemäßen Verfahren wird vorzugsweise eine periodische Hin- und Herbewegung der Innenelektrode oder der Außenelektrode durchgeführt, wobei der Hub dieser Bewegung größer als die Ausdehnung des im statischen Fall erzielten Abscheideprofils ist, vorzugsweise ein Mehrfaches davon beträgt.

Dabei wird vorzugsweise ein Edelgas zusammen mit einem oxidierenden Gas, das weder Kohlenstoff noch Fluor enthält, verwendet. Insbesondere werden Ar/O₂ oder Ar/H₂O, Ar/NO₂ und/oder in Abfolge Ar/H₂ und Ar verwendet.

Vorzugsweise wird zwischen jeweils zwei Plasmabehandlungen eine Einzelschicht aus Mehrkomponentenmaterial mit einer Dicke von höchstens 0,5 µm, insbesondere weniger als 0,1 µm Dicke abgeschieden.

Bei der räumlichen Veränderung der Gasphasen-Zusammensetzung können z.B. WF₆ + H₂(+Ar) einerseits und Ar + metallorganische Verbindungen + oxidierendes Gas andererseits, über die räumlich getrennten Gaseinlässe in getrennte Plasmabereiche eingebracht werden.

Dabei ist es vorteilhaft, den Abstand zwischen zwei Gaseinlässen für zwei verschiedene Komponenten der Gasphase bei fest vorgegebenen Verfahrensparametern so einzustellen, daß die Abscheidungsmaxima für beide Komponenten im statischen Fall aufeinanderfallen.

Besonders vorteilhaft ist es, eine Zwei- oder Mehrkomponenten-Simultan-Abscheidung durchzuführen, wobei die einzelnen Komponenten der Gasphase über räumlich getrennte Gaseinlässe in getrennte Plasmabereiche eingebracht werden und bei der periodischen Hin- und Herbewegung der Innen- oder Außenelektrode (also bei der Elektroden-Relativbewegung, die eine periodische Plasmaverschiebung zur Folge hat) intermittierende Plasma-Zwischenbehandlungen eingeschoben werden. Dabei wird der Abstand zwischen den Gaseinlässen vorzugsweise so eingestellt, daß die Abscheidungsmaxima für die beiden Hauptkomponenten im statischen Fall aufeinanderfallen.

Dadurch, daß der strömenden Gasphase, wie bereits erwähnt, fluorfreie metallorganische Ausgangsverbindungen zugesetzt werden, wird der Einbau von Fluor oder Fluorverbindungen in das Mehrkomponentenmaterial vermindert. Diese Maßnahme beruht auf Untersuchungen, bei denen als Sc-Quelle zunächst Scandium (trifluoracetylacetonat)₃ = Sc(tfa)₃ oder Scandium (hexafluoracetylacetonat)₃ = Sc(hfa)₃ = Sc(C₅HF₆O₂)₃ verwendet wurden, vor allem wegen ihres relativ hohen Dampfdrucks, wobei Ar als Trägergas diente, das durch einen mit pulverförmigem Ausgangsmaterial gefüllten Verdampfer in den Reaktor strömte. Um jedoch Sc₂O₃ statt ScF₃ über PCVD zu erhalten, wurde zusätzlich ein oxidierendes Gas beigegeben: Untersucht wurden N₂O, CO₂, H₂O-Dampf in Argon (=nasses Argon) und O₂, die bereits mit dem Ar-Trägergas durch den Verdampfer eingeleitet wurden. Das Resultat war jedoch wiederum ScF₃-Abscheidung per PCVD (Wandtemperaturen in der Regel etwa 370°C, untersuchter Bereich 250 bis 660°C). Nur bei Sc(tfa)₃ in sehr nassem Argon (Waschflasche erhitzt auf 40°C) + 10 sccm O₂ und bei einem Druck von 25 mbar wurde zusätzlich zu ScF₃ erstmals die bisher unbekannte Sc-Phase Sc_{0,1}WO₃ = Scandium-Wolframat erhalten.

Außerdem läßt sich bei metallorganischen Ausgangsverbindungen wie z.B. ScC₁₅H₁₂F₉O₆ = Sc(tfa)₃ die PCVD-Mitabscheidung von einigen % C kaum vermeiden. ScF₃ ist übrigens unter 900 K die thermodynamisch stabile Sc-Phase bei obigem Gasgemisch, Sc₂O₃ oder Sc₆WO₁₂ sind erst etwa bei T ≧ 1000 K stabiler, jedoch gehen bei so hohen Substrattemperaturen die Vorteile des PCVD-Verfahrens verloren, z.B. die Uniformität.

Daher wurde als neue Sc-Ausgangsverbindung fluorfreies Scandium-(acetylacetonat)₃ = Sc(C₅H₇O₂)₃ = Sc(aa)₃ gewählt. Zusammen mit nassem Ar oder trockenem Ar und O₂ als oxidierendem Gas wurden so erstmals Sc₂O₃ und/oder Scandiumwolframate erhalten (Sc_{0,1}WO₃, Sc_{0,2}W_{0,85}O₃, Sc₆WO₁₂). Allerdings befindet sich dann immer noch Kohlenstoff in Form von W-Karbid im abgeschiedenen Festkörper. ScF₃ wird noch im Bereich des Gaseintritts gefunden. Daß jedoch im Plasma vor allem die sauerstoffhaltigen Phasen gebildet werden, wird dadurch plausibel, daß die Sc-Verbindung nunmehr fluorfrei ist und das aus WF₆ + H₂ frei werdende Fluor als stabiles HF im Gas abgesaugt wird. Die Wahrscheinlichkeit für einen F-Einfang durch Sc nimmt ab.

Da z.B. bei einer I-Kathode mit PCVD-Sc₂O₃ + W-Deckschicht eine Kohlenstoff-Kodeposition in der Deckschicht unerwünscht ist, wurde der Kohlenstoff durch intermittierende Plasma-Zwischenbehandlung aus der gerade abgeschiedenen dünnen Einzelschicht wieder entfernt und die Gesamt-Deckschicht wurde aus einer Sequenz von mehreren bis sehr vielen dünnen Einzelschichten gebildet, die jeweils einer Plasmabehandlung unterzogen wurden.

Dazu werden erfindungsgemäß bei periodisch hin- und herbewegtem Plasma in der einen Richtung aus der zuvor beschriebenen Gasphase Sc, W (und O, F und C) abgeschieden. Im Umkehrpunkt werden die eingeleiteten Gase auf Umweg geschaltet und statt dessen werden nur Ar und O₂ (z.B. 270 sccm Ar und 55 sccm O₂) durch den Reaktor geleitet. Bei der Rückwärtsbewegung brennt also ein Ar/O₂-Plasma, und C wird als CO/CO₂ wieder über die Gasphase entfernt. Bei räumlich unterschiedlichen Konzentrationsmaxima von Sc, W und C bei der PCVD-Abscheidung werden die Beschichtungsrichtung und die Bewegungsrichtung der Anode bei der Plasma-Zwischenbehandlung z.B. derart gewählt, daß bei der Anodenbewegung in Richtung der Gasströmung (bei der praktischen Durchführung in Anti-Schwerkraftrichtung) beschichtet und in der Gegenrichtung mittels Plasma zwischenbehandelt wird. Gegebenenfalls wird eine Abfolge von Zwischenbehandlungen z.B. mit Ar/O₂-Plasma, Ar/H₂-Plasma und Ar-Plasma durchgeführt, z.B. sukzessive jeweils in Halbzyklen (entsprechend einer Richtung der Anodenbewegung). Außerdem wird gegebenenfalls die Geschwindigkeit der Anodenbewegung bei der Plasma-Zwischenbehandlung geändert oder es wird eine andere Einwirkungsdauer des Plasmas bei der Zwischenbehandlung im Vergleich zum PCVD-Einzelintervall gewählt.

Eine SAM-Analyse (SAM = Scanning Auger Microscopy) der Einzelschicht (mit Absputtern zum Erhalt eines Konzentrations-Tiefenprofils) ergab, daß die maximale Sc-Konzentration am Beginn der Glimmentladung in Strömungsrichtung (= Anodenspitze) auftritt, W vor allem in der Mitte (Anodenaufdickung) und C zum Ende der Plasmazone (Richtung Gaseinlaß = Anodenzuführungshülsen) hin (aber auch zusammen mit Sc) abgeschieden wird. Führt man nun das PCVD-Abscheidungsintervall während der Anodenbewegung entgegen der Strömungsrichtung durch, so ist die höchste C-Konzentration im momentanen Oberflächenbereich, und es wird ein guter C-Abbau bei der Ar/O₂-Plasmabehandlung während der Rückwärtsbewegung in Strömungsrichtung erreicht. In Röntgendiffraktions-Aufnahmen der so hergestellten Schichten konnte keine kohlenstoffhaltige Phase mehr gefunden werden. SAM-Profile zeigen, daß der C-Gehalt von etwa 30 bis 40 Mol% auf weniger als 1% reduziert werden konnte, ohne bereits die gerade erläuterte zusätzliche Verbesserung (= Plasmabehandlung entgegen der Strömungsrichtung) anzuwenden.

In diesem Zusammenhang soll darauf hingewiesen werden, daß bei der Th/W-PCVD eine ähnliche Behandlung durchgeführt wurde, um dünne Zwischenschichten von ThF₄, die durch thermische CVD außerhalb des Plasmas entstehen, und weiteren F-Einbau in der PCVD-Schicht zu vermeiden und die Schichten wieder fluorfrei zu bekommen. Dazu wurde die in einer Bewegungsrichtung abgeschiedene Schicht in der Gegenrichtung der Anodenbewegung einer reinen Ar-Glimmentladung ausgesetzt. SAM-Untersuchungen zeigten, daß die so hergestellten Schichten frei von Fluor waren, der dort jedoch erwünschte Kohlenstoff in den Schichten verbleibt.

Eine weitere erfindungsgemäße Maßnahme, um bereits die W-Karbidbildung bei der PCVD zu unterbinden, besteht darin, in getrennten Plasmazonen zuerst in Strömungsrichtung W-Abscheidung und anschließend Sc-Abscheidung (d.h. Sc₂O₃) durchzuführen, so daß C-haltige flüchtige Reaktionsprodukte nicht mehr mit W reagieren können. Dazu können zwei verschiedene Gaseinlaß-und Anodenkonstruktionen verwendet werden, die anhand einer Zeichnung erläutert werden.

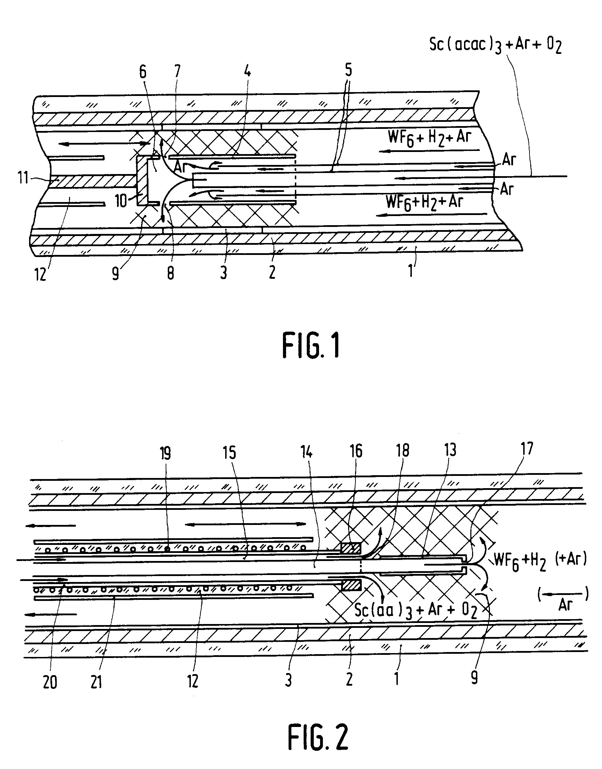

In der Zeichnung zeigen
Fig. 1 und 2 je einen Ausschnitt aus zwei unterschiedlich gestalteten PCVD-Vorrichtungen schematisch im Schnitt.

Fig. 1 zeigt ein Reaktorrohr, bestehend aus einem äußeren Quarzrohr 1, einem darin angeordneten Edelstahlzylinder 2 und einem darin angeordneten Substratzylinder 3. Innerhalb des Substratzylinders ist ein Anodenkopf angeordnet, ausgebildet als Hohlanode 4, in die, wie durch Pfeile angedeutet ist, durch ein ortsfestes Quarzrohr 5 eine Sc-Ausgangsverbindung mit Ar-Trägergas und O₂ in einen Hohlraum 6 einströmt und durch Öffnungen 7 und 8 auf der Zuführungsseite in eine Plasmazone, hier eine Glimmentladungszone 9, ausströmt und dort zerlegt und als Sc-Oxid (oder -Wolframat) auf dem Substratzylinder 3 abgeschieden wird. Während der Abscheidung wird die Hohlanode 4, die über eine Halterung 10 mit einem beweglichen Stab 11 verbunden ist, hin und her bewegt, was durch einen Doppelpfeil angedeutet ist. Der Stab ist von einem Totvolumen 12 umgeben, durch das Abscheidungen an unerwünschten Stellen verhindert werden.

Um zu vermeiden, daß sich Sc(F₃) bereits im Innern der Hohlanode, die ja durch das Plasma aufgeheizt ist, abscheidet, wird entweder durch eine Doppelrohrkonstruktion des Rohres 5 (zwei ineinander geschachtelte Quarzrohre) zusätzlich Ar als Spülgas in die Hohlanode eingeblasen, oder die Hohlanode wird zusätzlich gekühlt (hier nicht dargestellt).

WF₆ + H₂ + Ar strömt von der anodenabgewandten Seite her in das Reaktorrohr ein, und W wird schon zu Beginn der Entladungszone abgeschieden.

Fig. 2 zeigt eine doppelwandige Hohlrohranode mit einem Anodenkopf 13, bei der beide Komponenten getrennt durch ein Innenrohr 14 und durch einen Hohlrohrmantel 15 mit einer Aufdickung 16 eingeführt werden, wobei WF₆ + H₂ (+Ar) und Sc(aa)₃ + Ar + O₂ durch getrennte Öffnungen 17 und 18 in die Plasmazone 9 eintreten, und zwar so, daß in Absaugungsrichtung zuerst Sc-Oxid abgeschieden wird (Zuführungsseite) und W im Bereich der Anodenspitze abgeschieden wird.

Der Hohlrohrmantel 15 ist von einer Anodenheizung 19, einer Al₂O₃-Isolation 20 und einer Anodenzuführungshülse 21 aus Graphit umgeben.

Dazu ist dann auch eine zusätzliche Verdickung im Bereich der Anodenspitze bei 17 empfehlenswert (nicht dargestellt). Legt man die Absaugungsrichtung zur anodenabgewandten Seite, so müssen entsprechend WF₆-und Sc(aa)₃-Zuführung vertauscht werden; WF₆ und H₂ werden dann durch den Hohlrohrmantel 15 eingeleitet und treten zuerst in die Plasmazone aus; Sc(aa)₃ + Ar + O₂ strömen durch das zentrale Zuführungsrohr 14 an der Anodenspitze aus, so daß C-haltige Molekülreste sofort vom Rand der Plasmazone weggesaugt werden und kein W-Karbid mehr per Plasma abgeschieden werden kann.

Die Temperatur der Sc(aa)₃-Zuführungs-Rohrwände muß dabei auf Verdampfertemperatur (z.B. 165°C) gehalten werden, wofür zusätzliche Heizwicklungen vorgesehen sind.

Bei einer Variante der Anordnung von Fig. 2 wird der Abstand zwischen den Gaseinlässen 17 und 18 so eingestellt, daß die Maxima der im statischen Fall erzielten Konzentrationsprofile für jede der beiden Metallkomponenten, hier also für W und für Sc, aufeinanderfallen. Das hat zur Folge, daß bei der dynamischen Abscheidung mit hin- und herbewegtem Plasma die in vielen Fällen unerwünschte starke Konzentrationsmodulation über die Schichttiefe stark verringert werden kann, so daß eine Uniformität der PCVD-Schicht nicht nur in axialer Richtung, sondern auch in radialer Richtung über die Schichtdicke erzielt wird.

Gegebenenfalls wird auch das mit der Anordnung in Fig. 2 durchgeführte Verfahren mit einer intermittierenden, z.B. Ar/O₂-Plasma-Zwischenbehandlung durchgeführt, wodurch eine weitere Verringerung des Restkohlenstoffs erreicht wird.

Das erfindungsgemäße Verfahren läßt sich nicht nur mit Sc(aa)₃ + O₂ + WF₆ + H₂ durchführen, sondern auch für andere Mehrkomponentensysteme, z.B. mit β-Diketonaten der Scandium-Gruppe (IIIB-Gruppe) und mit Fluoriden der Übergangs- bzw. Refraktärmetalle als Ausgangsverbindungen oder z.B. bei PCVD von Seltenerdmetall-β-diketonaten, Erdalkali-β-diketonaten und Übergangsmetall/Cu-β-diketonaten oder von anderen metallorganischen Verbindungen dieser Elemente zum Erhalt der entsprechenden reinen oxidischen Festkörperphasen.

Um Ausbeuteverluste beim Umschalten der reaktiven Gase auf Umweg zu vemeiden, ist es vorteilhaft, das erfindungsgemäße Verfahren in zwei Zwillingsapparaturen durchzuführen, in denen jeweils alternierend Abscheidung und Plasma-Zwischenbehandlung durchgeführt werden und die reaktiven Gase von einem zum anderen Reaktor hin- und hergeschaltet werden.

## Patentansprüche

1. Verfahren zur plasmaaktivierten reaktiven Abscheidung von elektrisch leitendem Mehrkomponentenmaterial aus einer strömenden Gasphase auf einem rohrförmigen Substrat, wobei das Plasma zwischen einer Innenelektrode und einer Außenelektrode, von denen eine rohrförmig ausgebildet ist und als Substrat dient, erzeugt wird,
dadurch gekennzeichnet, daß die Zusammensetzung der Gasphase zeitlich und/oder räumlich verändert wird, indem zwischen reaktiven Abscheidungsphasen Plasma-Zwischenbehandlungen durchgeführt und/oder einzelne Komponenten der Gasphase über räumlich getrennte Gaseinlässe in getrennte Plasmabereiche eingebracht werden.

2. Verfahren nach Anspruch 1,
dadurch gekennzeichnet, daß der strömenden Gasphase als Ausgangsmaterial für das Mehrkomponentenmaterial flüchtige Metallverbindungen zugesetzt werden.

3. Verfahren nach Anspruch 2,
dadurch gekennzeichnet, daß der strömenden Gasphase Metallhalogenide und metallorganische Verbindungen als Komponenten zugesetzt werden.

4. Verfahren nach Anspruch 2 oder 3,
dadurch gekennzeichnet, daß der strömenden Gasphase fluorfreie metallorganische Verbindungen zugesetzt werden.

5. Verfahren nach Anspruch 1 oder 2,
dadurch gekennzeichnet, daß eine periodische Hin- und Herbewegung der Innenelektrode oder der Außenelektrode durchgeführt wird, wobei der Hub dieser Bewegung größer als die Ausdehnung des im statischen Fall erzielten Abscheideprofils ist.

6. Verfahren nach Anspruch 5,
dadurch gekennzeichnet, daß der Hub ein Mehrfaches der Ausdehnung des im statischen Fall erzielten Abscheideprofils beträgt.

7. Verfahren nach Anspruch 1,2 oder 5,
dadurch gekennzeichnet, daß bei der Plasma-Zwischenbehandlung ein Edelgas zusammen mit einem oxidierenden Gas, das weder Kohlenstoff noch Fluor enthält, verwendet wird.

8. Verfahren nach Anspruch 7,
dadurch gekennzeichnet, daß bei der Plasma-Zwischenbehandlung Ar/O₂ oder Ar/H₂O, Ar/N₂O und/oder in Abfolge Ar/H₂ und Ar verwendet werden.

9. Verfahren nach Anspruch 1,2,5,7 oder 8,
dadurch gekennzeichnet, daß zwischen jeweils zwei Plasmabehandlungen eine Einzelschicht aus Mehrkomponentenmaterial mit einer Dicke von höchstens 0,5 µm abgeschieden wird.

10. Verfahren nach Anspruch 9,
dadurch gekennzeichnet, daß jeweils eine weniger als 0,1 µm dicke Einzelschicht abgeschieden wird.

11. Verfahren nach Anspruch 1,2 oder 5,
dadurch gekennzeichnet, daß der Abstand zwischen zwei Gaseinlässen für zwei verschiedene Komponenten der Gasphase bei fest vorgegebenen Verfahrensparametern so eingestellt wird, daß die Abscheidungsmaxima für beide Komponenten im statischen Fall aufeinanderfallen.

12. Verfahren nach Anspruch 1 oder 5,
dadurch gekennzeichnet, daß eine Zwei- oder Mehrkomponenten-Simultan-Abscheidung durchgeführt wird, wobei die einzelnen Komponenten der Gasphase über räumlich getrennte Gaseinlässe in getrennte Plasmabereiche eingebracht werden und bei der periodischen Hin- und Herbewegung der Innen- oder Außenelektrode intermittierende Plasma-Zwischenbehandlungen eingeschoben werden.

13. Verfahren nach Anspruch 12,
dadurch gekennzeichnet, daß der Abstand zwischen den Gaseinlässen so eingestellt wird, daß die Abscheidungsmaxima für die beiden Hauptkomponenten im statischen Fall aufeinanderfallen.

14. Verfahren nach einem oder mehreren der vorhergehenden Ansprüche,
dadurch gekennzeichnet, daß das Verfahren in zwei Zwillingsapparaturen durchgeführt wird, in denen jeweils alternierend Abscheidung und Plasma-Zwischenbehandlung durchgeführt werden und die reaktiven Gase von einem zum anderen Reaktor hin- und hergeschaltet werden.

## Claims

1. A method for the plasma-activated reactive deposition of electrically conductive multicomponent material from a flowing gas phase on a tubular substrate, in which the plasma is produced between an inner electrode and an outer electrode, one of which is tubular and serves as a substrate, characterized in that the composition of the gas phase is changed as a function of time and/or place, in that between reactive deposition phases intermediate plasma treatments are carried out and/or single components of the gas phase are introduced into separate plasma zones through physically separated gas inlets.

2. A method as claimed in Claim 1, characterized in that, as the starting material for the multicomponent material, volatile metal compounds are added to the flowing gas phase.

3. A method as claimed in Claim 2, characterized in that metal halogenides and metalorganic compounds are added to the flowing gas phase as components.

4. A method as claimed in Claim 2 or 3, characterized in that fluorine-free metalorganic compounds are added to the flowing gas phase.

5. A method as claimed in Claim 1 or 2, characterized in that a periodical reciprocating movement of the inner electrode or the outer electrode is carried out, the stroke of this movement being larger than the expansion of the deposition profile obtained in the static condition.

6. A method as claimed in Claim 5, characterized in that the stroke is a multiple of the expansion of the deposition profile obtained in the static condition.

7. A method as claimed in Claim 1, 2 or 5, characterized in that in the intermediate plasma treatment an inert gas is used together with an oxidizing gas which contains neither carbon nor fluorine.

8. A method as claimed in Claim 7, characterized in that in the intermediate plasma treatment Ar/O₂ or Ar/H₂O, Ar/N₂O and/or in succession Ar/H₂ and Ar are used.

9. A method as claimed in Claim 1, 2, 5, 7 or 8, characterized in that a single layer of a multicomponent material having a thickness of at most 0.5 µm is deposited between every two plasma treatments.

10. A method as claimed in Claim 9, characterized in that each time a single layer having a thickness smaller than 0.1 µm is deposited.

11. A method as claimed in Claim 1, 2 or 5, characterized in that in the case of predetermined process parameters, the distance between two gas inlets for two different components of the gas phase is adjusted so that the deposition maxima of both components are equal to each other in the static condition.

12. A method as claimed in Claim 1 or 5, characterized in that two or more components are deposited simultaneously, the single components of the gas phase being introduced into separate plasma zones through physically separated gas inlets, and intermittent intermediate plasma treatments being carried out during the periodic reciprocating movement of the inner and outer electrode.

13. A method as claimed in Claim 12, characterized in that the distance between the gas inlets is adjusted so that in the static condition the deposition maxima are equal for both main components.

14. A method as claimed in one or more than one of the preceding Claims, characterized in that the method is conducted in two twin devices, in which deposition and plasma intermediate treatment are carried out alternately, and the reactive gases are switched from one reactor to the other.

## Revendications

1. Procédé de dépôt réactif activé par plasma d'un matériau à plusieurs constituants à partir d'une phase gazeuse courante sur un substrat tubulaire, le plasma étant engendré entre une électrode intérieure et une électrode extérieure dont l'une est conçue en forme de tube et qui fait office de substrat, caractérisé en ce que la composition de la phase gazeuse est changée temporellement et/ou spatialement du fait que, entre des phases de dépôt réactives, on effectue des traitements intermédiaires par plasma et/ou que l'on introduit des constituants individuels de la phase gazeuse dans des zones de plasma individuelles par l'intermédiaire d'entrées de gaz séparées dans l'espace.

2. Procédé selon la revendication 1, caractérisé en ce que l'on ajoute des composés métalliques volatils comme matériau de départ pour le matériau à plusieurs constituants à la phase gazeuse courante.

3. Procédé selon la revendication 2, caractérisé en ce que l'on ajoute des halogénures ainsi que des composés organométalliques comme constituants à la phase gazeuse courante.

4. Procédé selon la revendication 2 ou 3, caractérisé en ce que l'on ajoute des composés organométalliques exempts de fluor à la phase gazeuse courante.

5. Procédé selon la revendication 1 ou 2, caractérisé en ce que l'électrode intérieure soit l'électrode extérieure effectue un mouvement de va-et-vient périodique, la course de ce mouvement étant supérieure à la dilatation du profil de dépôt obtenu dans le cas statique.

6. Procédé selon la revendication 5, caractérisé en ce que la course constitue un multiple de la dilatation du profil de dépôt obtenu dans le cas statique.

7. Procédé selon la revendication 1, 2 ou 5, caractérisé en ce que, lors du traitement intermédiaire par plasma, on utilise un gaz rare conjointement avec un gaz oxydant contenant ni du carbone ni du fluor.

8. Procédé selon la revendication 7, caractérisé en ce que, lors du traitement intermédiaire par plasma, on utilise du Ar/O₂ ou du Ar/H₂O, du Ar/N₂O et/ou en ordre de suite du Ar/H₂ et du Ar.

9. Procédé selon la revendication 1, 2, 5, 7 ou 8, caractérisé en ce qu'une couche constituée de matériau à constituants multiples présentant une épaisseur maximale de 0,5 µm est déposée chaque fois entre deux traitements par plasma.

10. Procédé selon la revendication 9, caractérisé en ce qu'une couche inférieure à une épaisseur de 0,1 µm est déposée chaque fois.

11. Procédé selon la revendication 1, 2 ou 5, caractérisé en ce que dans le cas de paramètres de procédé prédéfinis, l'écartement entre deux entrées de gaz destinées pour deux constituants différents de la phase gazeuse est réglé de manière que les maximums de dépôt des deux constituants coïncident dans le cas statique.

12. Procédé selon la revendication 1 ou 5, caractérisé en ce qu'un dépôt simultané de deux ou de plusieurs constituants est effectué, les constituants individuels de la phase gazeuse étant introduits dans les zones de plasma individuelles par l'intermédiaire d'entrées de gaz séparées dans l'espace, et en ce que des traitements intermittents intermédiaires par plasma sont intercalés lors du mouvement de va-et-vient périodique effectué par les électrodes intérieure ou extérieure.

13. Procédé selon la revendication 12, caractérisé en ce que l'écartement entre les entrées de gaz est réglé de manière que les maximums de dépôt des deux constituants principaux coïncident dans le cas statique.

14. Procédé selon l'une quelconque des revendications précédentes, caractérisé en que le procédé est mis en oeuvre dans deux dispositifs jumelés dans lesquels sont alternés un dépôt et un traitement par plasma et dans lesquels les gaz réactifs sont commutés de manière à faire la navette entre les deux réacteurs.
